# EUROPEAN PATENT APPLICATION

(11) **EP 4 443 672 A2**
(43) Date of publication of application: **09.10.2024**
(21) Application number: 24174431.7
(22) Date of filing: 13.06.2023
(51) Int. Cl.: H01S 5/16

(54) **HETEROGENEOUS LASERS WITH FACETS OPTIMIZED FOR HIGH POWER**

(30) Priority: 29.03.2023 US 202318127983
(62) Divisional of application: 23178849.8
(71) Applicant: Nexus Photonics, Inc., Goleta, CA 93117 (US)
(72) Inventor: Komljenovic, Tin, Goleta, 93117 (US); Zhang, Zeyu, Goleta, 93117 (US); Zhang, Chong, Santa Barbara, 93111 (US); Tran, Minh, Goleta, 93117 (US)
(74) Representative: Isarpatent

(57) **Abstract**

A device is made up of an active structure attached to a substrate, the active structure having a facet through which light couples between the active structure and another structure attached to the substrate; and an active region comprising a quantum well region that includes a sub-region, adjacent the facet, configured to undergo QWI in response to heat. The active structure also contains a heating element, positioned close to the facet and operable such that heat generated by the heating element raises a temperature of the sub-region of the active region near the facet high enough to activate QWI in that sub-region, in turn causing a reduction in optical absorption, without raising temperatures in any other portion of the active region enough to cause significant thermal stress at any interface between the substrate and the active structure.

## Description

### Field of the Invention

The present invention relates to photonic integrated circuits. More specifically, certain embodiments of the invention relate to improved performance of heterogeneously integrated lasers and active components.

### Background of the Invention

A photonic integrated circuit (PIC) or integrated optical circuit is a device that integrates multiple photonic functions and as such is analogous to an electronic integrated circuit. The major difference between the two is that a photonic integrated circuit provides functions for information signals imposed on optical carrier waves. A photonic integrated circuit can also generate light with advanced properties in one chip. The material platform most commercially utilized for photonic integrated circuits is indium phosphide (InP), which allows for the integration of various optically active and passive functions on the same chip. Although many current PICs are realized in InP platforms, there has been significant research in the past decade in using silicon rather than InP for the realization of PICs, due to some superior characteristics as well as superior processing capabilities for the former material, that leverage the investment already made for electronic integrated circuits.

The biggest drawback in using silicon for PICs is that it is an indirect bandgap material which makes it hard to provide electrically pumped sources. This problem is generally solved by assembling PICs comprising two or more chips made from dissimilar materials in separate processes. Such an approach is challenging due to a need for very fine alignment, which increases packaging costs and introduces scaling limitations. Another approach to solving the bandgap problem is to bond two dissimilar materials and process them together, removing the need for precise alignment during the bonding of larger pieces or complete wafers of the dissimilar materials, and allowing for mass fabrication. In this disclosure, we use the term "hybrid" to describe the first approach that includes precise assembly of separately processed parts, and we use the term "heterogeneous" to describe the latter approach of bonding two materials and then processing the bonded result to define the waveguides and other components of interest.

To transfer the optical signal between dissimilar materials, the heterogeneous approach historically utilized tapers whose dimensions are gradually reduced until the effective mode refractive indexes of two or more materials match and there is efficient power transfer. This approach generally works well when materials have small difference in refractive indexes as is the case with silicon and InP. In cases where there is larger difference in effective indexes, such as between e.g. SiN and GaAs or InP, the requirements on taper tip dimensions become prohibitive limiting efficient power transfer.

Recently, a new class of heterogeneous PICs has been developed as described in e.g. US Patent No. US 11,209,592 B2 and US patent application 17,732,348 in which integration of optically dissimilar materials is facilitated without using prohibitively narrow tapers. The approach utilizes butt-coupling assisted optical coupling between materials with large refractive index difference and generally have at least one etched facet as a part of the laser structure. Such PICs have demonstrated very good performance, especially in terms of laser noise (both frequency and amplitude) - primarily leveraging the low losses in the passive/waveguide material. At the same time, output powers of such lasers are generally limited to below 30 milliwatts (mW), very rarely as high as 100 mW, due to the resulting high intensity of the optical mode in the quantum well region. Such high intensities can result in catastrophic optical mirror damage (COMD) if such lasers are operated at the high end of the output power.

Many applications require higher powered lasers, exceeding 100 mW, and approaching or even exceeding 1 watt (W). Such high powers can readily be supported by the passive waveguide realized in high-bandgap materials such as SiN, SiNOx, LiNbO₃, TiOz, TazOs, AlN or others, but laser/active structure, and especially the facet region have to be further optimized to provide such high powers without COMD and other impairments.

The present invention is directed towards heterogeneous lasers and PICs supporting high power operations. In particular, embodiments described below are concerned with the detailed design of the facet region for creation of high-performance, high-power heterogeneous lasers and PICs utilizing dissimilar materials.

### Brief Description of the Drawings

FIG. 1 shows a device according to one embodiment of the present invention, shown in cross section.
FIG. 2 shows a device according to one embodiment of the present invention, shown in cross-sectional end-on view and in cross-sectional top-down view.
FIG. 3 shows a device according to one embodiment of the present invention, shown in cross section.
FIG. 4 shows two cross-sectional end-on views of a device according to some embodiments of the present invention.
FIG. 5 shows two cross-sectional end-on views of a device according to some embodiments of the present invention.
FIG. 6 shows a cross-sectional top-down view of a device according to some embodiments of the present invention.

### Detailed Description

Described herein are embodiments of a platform for realization of photonic integrated circuits using wafer bonding and deposition of dissimilar materials where optical coupling is improved by use of mode conversion and a butt-coupling scheme. More specifically, certain embodiments of the invention relate to improved high-power performance of heterogeneously integrated lasers and PICs.

In the following detailed description, reference is made to the accompanying drawings which form a part hereof, wherein like numerals designate like parts throughout, and in which are shown by way of illustration embodiments in which the subject matter of the present disclosure may be practiced. It is to be understood that other embodiments may be utilized, and structural or logical changes may be made without departing from the scope of the present disclosure. Therefore, the following detailed description is not to be taken in a limiting sense, and the scope of embodiments is defined by the appended claims and their equivalents.

The description may use perspective-based descriptions such as top/bottom, in/out, over/under, and the like. Such descriptions are merely used to facilitate the discussion and are not intended to restrict the application of embodiments described herein to any particular orientation. The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B and C).

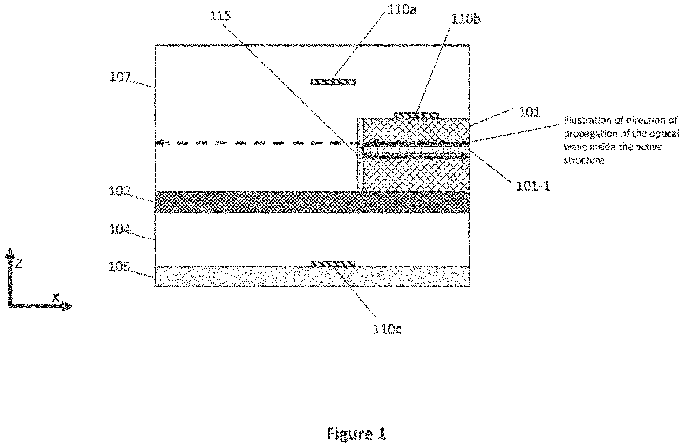

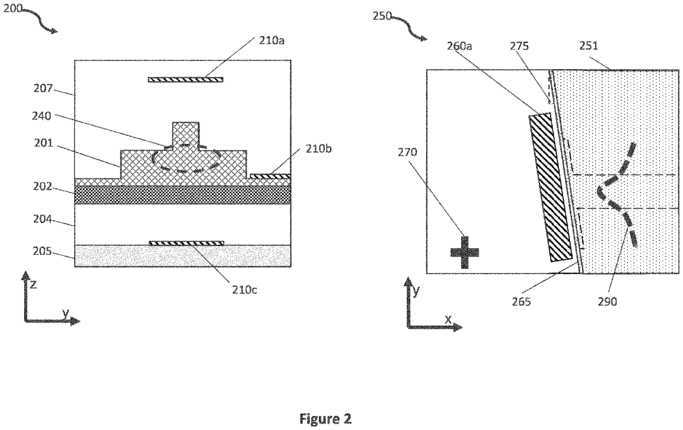

The term "coupled with," along with its derivatives, may be used herein. "Coupled" may mean one or more of the following. "Coupled" may mean that two or more elements are in direct physical, electrical, or optical contact. However, "coupled" may also mean that two or more elements indirectly contact each other, but yet still cooperate or interact with each other, and may mean that one or more other elements are coupled or connected between the elements that are said to be coupled with each other. The term "directly coupled" means that two or more elements are in direct contact in at least part of their surfaces. The term "butt-coupled" is used herein in its normal sense of meaning an "end-on" or axial coupling, where there is minimal or zero axial offset between the elements in question. The axial offset may be, for example, slightly greater than zero in cases where a thin intervening layer of some sort is formed between the elements, such as e.g. thin coating layer typically used to provide high-reflectivity, anti-reflectivity functionality or enhance some other property (e.g. enhancing quantum well intermixing as will be described with the help of FIG. 1). It should be noted that the axes of two waveguide structures or elements need not be colinear for them to be accurately described as being butt-coupled. In other words, the interface between the elements need not be perpendicular to either axis. FIG. 2 embodiments discussed below are exemplary of such possibilities. No adiabatic transformation occurs between butt-coupled structures.

Term "active device", "active structure" or otherwise "active" element, part, component may be used herein. A device or a part of a device called active is capable of light generation, amplification, modulation and/or detection using electrical contacts. This is in contrast to what we mean by a "passive device" whose principal function is to confine and guide light, and/or provide splitting, combining, filtering and/or other functionalities that are commonly associated with passive devices. Some passive devices can provide functions overlapping with active device functionality, such as e.g. phase tuning implemented using thermal effects or similar that can provide modulation. No absolute distinction should be assumed between "active" and "passive" based purely on material composition or device structure. A silicon device, for example, may be considered active under certain conditions of modulation, or detection of low wavelength radiation, but passive in most other situations.

FIG. 1 shows one embodiment of the present invention shown in cross-section view. The exemplary cross-section includes a substrate 105. The substrate 105 can be any suitable substrate for semiconductor and dielectric processing, such as Si, InP, GaAs, quartz, sapphire, glass, GaN, silicon-on-insulator or other materials known in the art. In the shown embodiment, a layer of a second material 104 is deposited, grown, transferred, bonded or otherwise attached to the top surface of substrate 105 using techniques known in the field. The main purpose of layer 104 is to provide optical cladding for material 102, if necessary to form an optical waveguide. In some embodiments, layer 104 is omitted and substrate 105 itself serves as a cladding.

Layer 102 is deposited, grown, transferred, bonded, or otherwise attached to the top of layer 104 if present, and/or to the top of substrate 105 if layer 104 is not present, using techniques known in the field. The refractive index of layer 102 is higher than the refractive index of layer 104 if present, or, if layer 104 is not present, the refractive index of layer 102 is higher than the refractive index of substrate 105. Layers 104 and/or 102 can be patterned, etched, or redeposited to tailor their functionality (define waveguides, splitters, couplers, gratings and other passive components) as is common in the art.

In one embodiment, the material of layer 102 may include, but is not limited to, one or more of SiN, SiNOₓ, TiOz, TazOs, (doped) SiO₂, LiNbO₃ and AlN. In some embodiments, other common dielectric materials may be used for layer 102. In other embodiments, a semiconductor material such as Si, InP, GaAs, (Al)GaAs, GaN or others may be used for layer 102.

Layer 101 is attached onto a top surface of layer 102, in the embodiment shown. In other embodiments, there could be additional thin layers between layer 102 and 101, to facilitate higher yield attachment and/or provide planarization of the top surface of 102 (if patterned). The attachment can utilize direct molecular bonding (with or without supporting thin layers) or can use additional materials to facilitate bonding such as e.g., metal layers or polymer films as is known in the art. Layer 101 makes up what is commonly called an active device and may be multilayered and/or patterned to provide optical and electrical confinement as is known in the art of active semiconductor devices such as optical sources, modulators, amplifiers and detectors. In some embodiments (not shown) the active device also has electrical contacts to provide electrical signals to control the device.

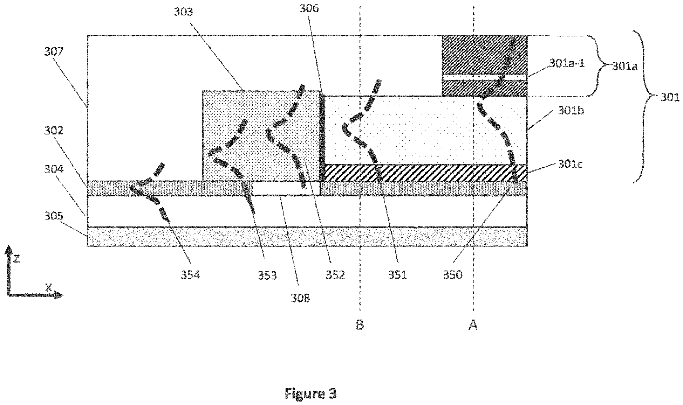

In some embodiments, not shown, an intermediate passive structure may be present to improve the coupling between active structure 101 and passive waveguide 102. An analogous situation is discussed with regard to FIG. 3, where intermediate structure 303 plays this role.

Layer 107 is deposited, grown, transferred, bonded, or otherwise attached to the multilayered structures on top of substrate 105. The upper cladding layer 107 for waveguides realized in layer 102 can be ambient air (meaning no cladding material is actually present) or can be any other deliberately attached suitable material as shown in FIG. 1, including, but not limited to, a polymer, SiOz, SiN, SiNOₓ etc. In some embodiments (not shown), layer 107 cladding functionality can be provided with multiple depositions and/or multiple materials to e.g. manage stress or provide additional functionality (e.g. surface passivation).

Layer 101 provides an active waveguide (using optical confinement as described above) that guides the wave along the x-axis and also illustrated with arrow in the FIG. 1. At least part of the optical mode resides in the sublayer (active region) 101-1 comprising quantum wells (QWs), quantum dots (QDs) and/or combination of both. A part of the light is reflected (illustrated with full line arrow), and a part is transmitted (illustrated with dashed arrow), with the ratio between the two depending on the reflectivity at the facet which typically varies from as low as 0.001% (-50 dB) to as high as 99.9%. Optical intensity of such mode can be high especially for high-power lasers (depending on the wavelength, but in some cases >100 mW) as mode volume is generally small (also depending on the wavelength) and in the order of 1 µm² to 10 µm². In other embodiments, mode size can be smaller or larger from the values above, and it is understood that it can be engineered such by properly designing the material composition and waveguide cross-section.

At high optical intensities, there is a common failure mechanism called catastrophic optical mirror damage (COMD). There can be many mechanisms leading to COMD related to optical absorption at the facet due to the formation and accumulation of defects, carrier generation, and/or non-radiative recombination resulting in temperature increase and bandgap reduction. When a critical temperature is reached, thermal runaway may be initiated, which leads to melting, and subsequent spatial propagation of the hot spot would seriously damage the device.

An effective way to increase COMD threshold power is to make the facet non-absorptive. A standard way to achieve this in the prior art is to implement quantum well intermixing (QWI) in and around layer 101-1 enabling the control of the quantum well bandgap to reduce the absorption. In the case of active region comprising quantum dots, quantum dot intermixing (QDI) can be implemented in similar way to tune the bandgap of the quantum dots. In the remainder of this disclosure, including the claims, the term "quantum well intermixing" is used for simplicity to include quantum well intermixing and quantum dot intermixing. Various approaches for QWI have been developed and they typically require a high temperature (>500 °C) anneal. Such temperatures can be utilized in monolithic photonic systems, e.g. if the complete PIC is grown in an InP-based or GaAs-based material system, but might not be applicable to heterogeneous photonic systems that include bonded materials with different coefficients of thermal expansion (CTE).

Embodiments of the present invention disclosed herein use localized heating to allow device operation at higher optical power densities than are currently possible due to the risk of COMD. An optical power density of over 10mW/µm² may be achievable, for example.

Heterogeneous processes typically have a temperature limitation due to the CTE mismatch between the substrate 105 and the bonded active layer 101. Such a limitation varies depending on the CTE mismatch between the particular materials present, but is generally below the temperatures needed for QWI activation. Typically, for a heterogeneous photonic integrated circuit wafer, temperatures must be kept below 450C for all time periods exceeding a few minutes.

In some embodiments of the present invention, this problem is addressed with the use of local heating elements 110a, 110b and/or 110c that enable very high temperatures to be achieved but only in regions very close to the facets. This reduces the problems of the CTE mismatch introduced stress mentioned above, as the majority of the wafer is not at elevated temperature and so thermal mismatch is strictly localized and can be accommodated by the bonding interface. Similarly, in some embodiments, wafers on which multiple active structures have been fabricated can be diced into smaller pieces or even singulated prior to using the heating elements for local activation, to reduce the effect of CTE mismatch further.

In some embodiments, the facet is coated with a layer 115 of one or more materials chosen to enhance the potential for QWI adjacent to the facet. In other words, when nearby heaters raise the local temperature, QWI is further enhanced near the facet due to the chemical composition of the facet coating. SiOz and TiOz are two examples of materials known to be QWI enhancers for GaAs-based materials. The deposition method can be optimized to have the coating material cover the entire etched facet and improve the QWI process.

Local heaters can be realized in multiple ways. One way is by depositing doped silicon or metals to provide resistive heating elements. It is preferable for the heater to be as close to the facet region as possible, but at the same time it has to be sufficiently far from the optical mode to prevent high propagation loss. The constraint can be understood in terms of limiting the effective interaction volume between the heater elements (that can be optically lossy if realized with e.g. metal or semiconductor material with bandgap lower than the photon energies) and the optical mode, to avoid increasing local optical modal losses above an acceptable value. In some cases, an increased loss of about 100% (compared to the loss without heater elements) may be acceptable if it is confined to a sufficiently limited propagation length and correspondingly volume. Quantifying "close" is generally not possible independent of the specific material systems and geometries involved in a given device embodiment as mode shapes and sizes can vary by more than an order of magnitude. The optimization is similar to optimization of a laser cross-section to optimize the internal loss as is known in the art of optical semiconductor devices.

In some embodiments a heater can be pre-deposited prior to deposition of layer 104 as suggested by heater 110c. In other embodiments a heater can be deposited on the top surface of active element 101, as suggested by heater 110b. In yet other embodiments, a heater can be deposited at a distance from element 101 as suggested by heater 110a. Other placements are possible without departing from the spirit of the invention.

Another way to achieve localized heating sufficient to initiate QWI is to use a focused beam from an external laser to be absorbed by a previously deposited heater element (such as 110a-110c) comprising a material selected in part for its absorptive properties, and positioned close to the facet. Again, the presence of a suitable material in facet coating 115 can further enhance the QWI caused by the local temperature increase.

One or more lithography alignment marks (not shown in this cross-sectional view, but see, for example, 270 in FIG. 2, described below) are present to facilitate precise alignment between the layers formed during various processing steps.

FIG. 2 shows one embodiment of the present invention in cross-sectional end-on view 200 and in cross-sectional top-down 250 views. Functional layers 201 to 210 in view 200 (unless explicitly defined differently) correspond to functional layers 101 to 110 as described in relation to FIG. 1. Functional layers 251 to 260 in view 250 (unless explicitly defined differently) correspond to functional layers 101 to 110 as described in relation to FIG. 1.

Cross-section end-on view 200 shows one embodiment in which optical mode 240 is confined by using at least one lateral etch (in y-direction) in layer 201. At least one of the local heating elements 210a, 210b and/or 210c is introduced in close proximity to the optical mode (and the facet as explained with the help of FIG. 1) to enable very high local temperatures to facilitate QWI.

Cross-section top-down view 250 shows one embodiment in which optical mode 290 is confined by using at least one lateral etch (in y-direction) in layer 251 as suggested by dashed line. At least one of the local heating elements 260a is introduced in close proximity to the optical mode (and the facet as explained with the help of FIG. 1) to enable very high local temperatures to facilitate QWI. Heating elements can be positioned at any of various locations if they are suitably close to the facet.

In the embodiment shown, there is a facet coating 265, of a material or materials that enhance the QWI. One or more lithography alignment marks 270 (only one is shown for simplicity) are used for precise alignment between various processing steps.

The facet can be perpendicular to the direction of propagation of the optical mode 290 (not shown) or it can be at a non-perpendicular orientation, as shown by angle 275. Angling can reduce back-reflection, as is known in the art. The facet coating itself may be designed to further control reflection.

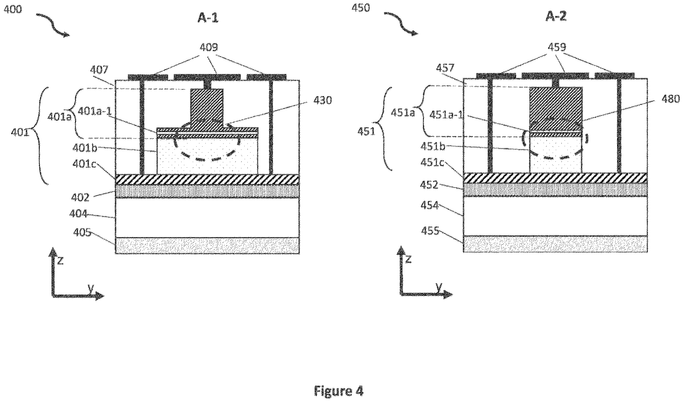

FIG. 3 is a schematic cross-section view of an embodiment of an integrated photonic device that incorporates an active structure and utilizes butt-coupling and evanescent coupling for efficient optical coupling between that structure and structures comprising dissimilar materials. The characteristic locations marked with "A" and "B" indicate locations to which the end-on or lateral cross-section views shown in FIGs. 4-5 may correspond. Note that there could be differences between embodiments shown in FIG. 3 and FIGs. 4-5.

The exemplary cross-section includes a substrate 305, that can be any suitable substrate for semiconductor and dielectric processing, such as Si, InP, GaAs, quartz, sapphire, glass, GaN, silicon-on-insulator or other materials known in the art. In the shown embodiment, a layer of a second material 304 is deposited, grown, transferred, bonded or otherwise attached to the top surface of substrate 305 using techniques known in the field. The main purpose of layer 304 is to provide optical cladding for material 302, if necessary to form an optical waveguide. In some embodiments, layer 304 is omitted and substrate 305 itself serves as a cladding.

Layer 302 is deposited, grown, transferred, bonded, or otherwise attached to the top of layer 304 if present, and/or to the top of substrate 305 if layer 304 is not present, using techniques known in the field. The refractive index of layer 302 is higher than the refractive index of layer 304 if present, or, if layer 304 is not present, the refractive index of layer 302 is higher than the refractive index of substrate 305. Layers 304 and/or 302 can be patterned, etched, or redeposited to tailor their functionality (define waveguides, splitters, couplers, gratings and other passive components) as is common in the art. In one embodiment, the material of layer 302 may include, but is not limited to, one or more of SiN, SiNOₓ, TiOz, TazOs, (doped) SiO₂, LiNbO₃ and AlN. In some embodiments, other common dielectric materials may be used for layer 302. In other embodiments, a semiconductor material such as Si, InP, GaAs, (Al)GaAs, GaN or others may be used for layer 302.

Layer 308, whose refractive index is lower than the refractive index of layer 302, serves to planarize the patterned surface of layer 302. In some embodiments, the planarity of the top surface of combined layers 302 and 308 is provided by chemical mechanical polishing (CMP) or other etching, chemical and/or mechanical polishing methods. In other embodiments, the planarity is provided because of the intrinsic nature of the method by which layer 308 is deposited, for example if the material of layer 308 is a spin-on glass, polymer, photoresist or other suitable material. In some embodiments both approaches are combined. The planarization may be controlled to leave a layer of desired, typically very low, thickness of layer 308 on top of the layer 302 (not shown), or to remove all material above the level of the top surface of the layer 302 (shown in FIG. 3). In the cases where layer 308 is left on top of layer 302, the target thicknesses are in the range of few nm to several hundreds of nm, with actual thickness, due to planarization process nonuniformities, being between zero and several hundreds of nanometers larger than the target thickness. In some embodiments, spin-on material is deposited and then etched back resulting with improved planarization across wafer uniformity compared to typical CMP processes. In yet another embodiment (not shown), there is no planarization layer 308 filling in the etched regions of layer 302. In this embodiment there would be depressions or pockets where layer 302 was etched.

Layer 301 is attached onto a top planarized surface suitably prepared as described in the previous paragraph. The attachment can utilize direct molecular bonding or can use additional materials to facilitate bonding such as e.g., metal layers or polymer films as is known in the art. Layer 301 makes up what is commonly called an active device and may be multilayered. In the embodiment shown in FIG. 3, layer 301 comprises sublayers that make up an active portion 301a, a passive portion 301b and a contact portion 301c. The active region 301a-1 comprising QWs and/or QDs, is present as a sublayer within active portion 301a. Each of the portions can provide additional functionality aside from the one specified by their names, e.g., the active portion 301a can also comprise one of the contact sublayers and/or the contact portion 301c can also comprise the bonding superlattice. Other additional functionalities can be included in particular sublayer including etch stop layers, electron blocking layers, graded doping layers, etc. Further details on the internal makeup of the active structure are given below.

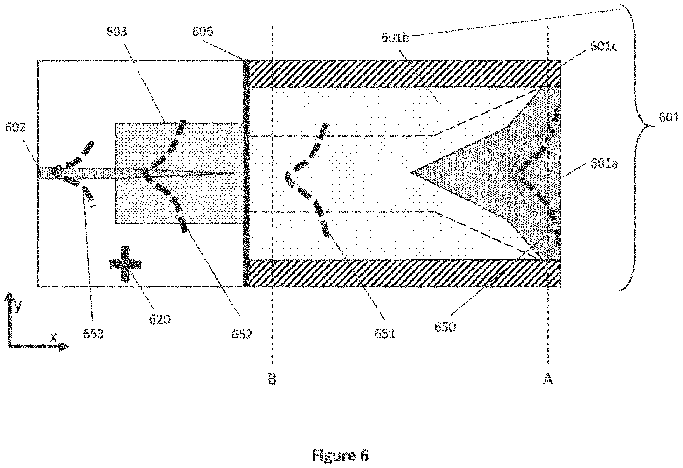

The lateral widths of sublayers within 301a-301c are not visible in this view but exemplary widths are shown in the views of FIGs. 4-5. The widths are defined by at least one etch after the bonding of layer 301. This facilitates precise alignment, as the etch can utilize common alignment marks 620 as indicated in FIG. 6.

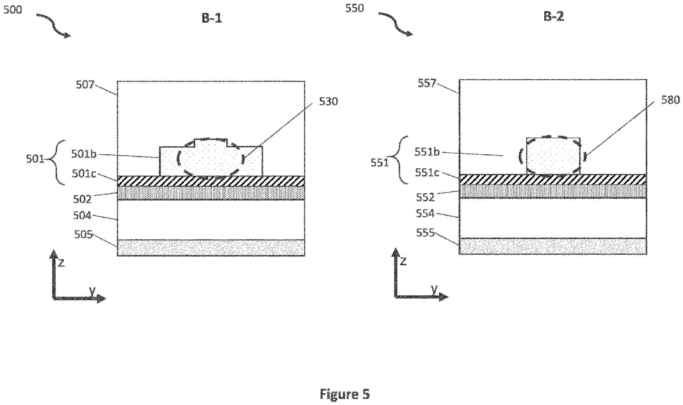

In some embodiments, layer 301 can be efficiently electrically pumped to generate optical emission and gain. The present invention enables efficient optical coupling between waveguides formed in layer 301 and layer 302, when layer 301 is optimized for high-power operation and includes two regions as also described in more details with the help of FIGs. 4-5. One region marked with "A" (and described in more details in FIG. 4) comprises the active region described in more details below, while a second region marked with "B" (and described in more details in FIG. 5) does not comprise the active region and is optimized for high-power facet operation.

The material(s) of layer 302 can provide additional functionality such as wide-band transparency, high intensity handling, phase shifting by temperature, strain or other tuning mechanisms, combining, splitting, filtering, non-linear generation and/or others as is known in the art.

Efficient coupling between waveguides realized in layer 301 and waveguides realized in layer 302 is facilitated by layer 303, and, in cases where layer 306 is present, by layer 306. Optional layer 306 primarily serves as either an anti-reflective or a highly-reflective coating at the interface between layer 301 and layer 303. Layer 303 is typically deposited to the top surface of layers 302 and/or 308. In other embodiments, layer 303 can be grown, transferred, bonded, or otherwise attached to the top surface of layers 302 and/or 308, using techniques known in the field. Layer 303 serves as an intermediate waveguide that in some embodiments accepts the profile (depicted by line 351) of an optical mode supported by the waveguide for which layer 301 in region marked with "B" provides the core, captures it efficiently as mode profile 352, and gradually transfers it to mode profiles 353, and finally 354. Mode profile 354 is efficiency coupled and supported in the waveguide for which layer 302 provides the core. The transition between mode 350 supported by layer 301 in region marked with "A" and mode 351 supported by layer 301 in region marked with "B" is facilitated by one or more taper structures as will be described with the help of FIG. 6. The requirements on taper dimensions for this transition are reduced as modal refractive indices in two regions "A" and "B" are smaller than e.g., refractive index difference between layer 301 and 302.

The refractive index and dimensions of layer 303 can be engineered to facilitate efficient butt-coupling of mode profile 351 and to efficiently transform the mode to one with mode profile 354 by taking advantage of tapered structures made in layer 302 and/or 303. The requirements on taper dimensions are reduced as refractive indices of layers 303 and 302 are typically smaller than the refractive index difference between layer 301 and 302. In some embodiments this transition can also utilize phase matching to transfer the energy similarly to an adiabatic or a directional coupler.

Differences between the optical modes supported by waveguides in layers 301 and 302 respectively may or may not be obvious by observation of the mode profiles, but mode overlaps less than 100% and vertical offset (z-axis in FIG. 3) between modes 351 and 354 could (in the absence of intermediate layer 303) result in significant optical loss. In some cases, it may be considered that losses of up to 2dB are acceptable, but losses greater than that are not. In other cases, a 5dB loss level may be the criterion chosen. The function of layer 303 is to keep optical coupling loss due to imperfect mode overlap and vertical offset below whatever is determined to be an acceptable level in a given application.

Sublayer 301a comprises active region 301a-1 of the active device. In some embodiments the active region 301a-1 comprises quantum well and/or quantum dot layers with optional separate-confinement heterostructure (SCH) layer(s). In the remainder of this disclosure, including the claims, the term "quantum well region" is used for simplicity to include quantum dot layers as well as quantum well layers.

Sublayer 301b comprises a waveguide region providing optical confinement of the mode 351. The region marked with "A" transitions to the region marked with "B" utilizing one or more taper structures in which mode 350, that overlaps at least in part with the active region 301a-1 to provide optical gain or absorption, is transferred to mode 351, that has no interaction/overlap with the active region. This enables higher powers at the facet (interface between 301 and 303) without COMD as the quantum well region in the active region is usually the most sensitive to negative effects of high intensity which can lead to COMD.

Sublayer 301c comprises at least one contact layer and optional superlattice layers to facilitate bonding and/or prevent dislocations propagation due to bonding or general device operation.

The upper cladding layer 307 for waveguides realized in 303 and/or 302 can be ambient air (meaning no cladding material is actually deposited) or can be any other deliberately deposited suitable material as shown in FIG. 3, including, but not limited to, a polymer, SiO2, SiN, SiNOx etc. In some embodiments, the same material is used for layer 307 and layer 308. In some embodiments (not shown), layer 307 cladding functionality can be provided with multiple depositions, e.g. one material provides the cladding for mode 354 guided by the core formed in layer 302, and another material provides the cladding for modes 353-352 guided by the core formed in layer 303. In all cases, the refractive index of the cladding material is lower than the refractive index of the material which provides the core to achieve mode guiding. In yet another embodiment (not shown here), layer 303 can provide cladding functionality to layer 302 and mode 354.

One or more lithography alignment marks (not shown in this cross-sectional view, but see, for example, 620 in FIG. 6, described below) are present to facilitate precise alignment between the layers formed during various processing steps.

It may be noted that several of the features (e.g., butt coupling, intermediate waveguides etc.,) included in the embodiments shown in FIG. 3 are disclosed in prior publications, such as U.S. Patent No. 1,071,889,8B1. The present invention includes additional optimization for high-power performance, and more specifically removal of the active region at the facet using one or more additional tapers in the active region.

FIG. 4 shows two embodiments of the present invention in cross-sectional end-on views 400 ("A-1") and 450 ("A-2") corresponding to an exemplary location such as that marked "A" in FIG. 3. Note that there could be additional differences between the embodiments shown in FIG. 3 and FIG. 4 than are shown or discussed here. Functional layers 401 to 407 (unless explicitly defined differently) correspond to functional layers 301 to 307 as described in relation to FIG. 3. Functional layers 451 to 457 (unless explicitly defined differently) correspond to functional layers 301 to 307 as described in relation to FIG. 3.

In embodiments shown in view 400 ("A-1"), the optical mode 430 is confined laterally by at least one etch in layer 401a forming a rib waveguide. At least part of the mode interacts with the active region 401a-1 which can provide efficient electrically injected gain, absorption, or modulation. Electrical contacts are realized through contact metal and pads 409. Various configurations of electrical connections can be realized as is known in the art of semiconductor devices. Contact metals usually have high optical losses, so good designs minimize the overlap between the optical mode 430 and metals 409. One optimization uses cladding in layer 401a to separate the mode from the metal on top of the optical mode (z-direction), and one optimization utilizes horizontal (y-direction) offset between the metals 409 and the optical mode. Confinement in the active region can be controlled by the layer 401 material composition and one or more etches. The advantages of the rib-based structure shown in view 400 are the reduced optical loss due to rib geometry (lower sidewall interaction) and reduced optical intensities at the etched interface of the active region which is wider (in y-direction) than the etch that defines the mode confinement.

In embodiments shown in view 450 ("A-2"), the optical mode 480 is confined laterally by at least one etch through both layer 401a and layer 401b forming a strip waveguide. At least part of the mode interacts with the active region 401a-1 which can provide efficient electrically injected gain, absorption, or modulation. The advantage of the strip geometry structure shown in view 450 is simplified processing with potentially reduced number of etches, and lower sensitivity to misalignment between different patterning steps, especially when considering the transition from "A" to "B" cross-sections. A disadvantage is that the optical mode has higher sidewall interaction and also interacts with the etched interface of the active region.

FIG. 5 shows two embodiments of the present invention in cross-sectional end-on views 500 ("B-1") and 550 ("B-2") corresponding to an exemplary location such as that marked "B" in FIG. 3. Note that there could be differences between embodiments shown in FIG. 3 and FIG. 5 other than those shown and discussed here. Functional layers 501 to 507 (unless explicitly defined differently) correspond to functional layers 301 to 307 as described in relation to FIG. 3. Functional layers 551 to 557 (unless explicitly defined differently) correspond to functional layers 301 to 307 as described in relation to FIG. 3.

In embodiments shown in view 500 ("B-1"), the optical mode 530 is confined laterally by at least one etch in layer 401b forming a rib waveguide. The advantage of the rib-based structure shown in view 500 is the reduced optical loss due to rib geometry (lower sidewall interaction). In embodiments shown in view 550 ("B-2"), the optical mode 580 is confined laterally by at least one etch through layer 401b forming a strip waveguide.

In designing the transitions from region "A" to "B", various combinations are possible, so it is possible to design a device in which "A-1" transitions to "B-1", but also a device in which "A-1" transitions to "B-2". This is done by utilizing three or more etches. Similarly, a device in which "A-2" transitions to "B-1", and a device in which "A-2" transitions to "B-2" can be designed.

In terms of fabrication, transition from "A-2" to "B-2" might be the simplest, but has disadvantages related to any strip waveguide as mentioned above. Transitioning from "A-1" to "B-1" might be the most complex and is specifically described with the help of FIG. 6.

FIG. 6 depicts a top-down view of an integrated photonic device according to one embodiment of the present invention in which the transition from an "A-1" to a "B-1" cross-section is described. Functional layers 601 to 606 (unless explicitly defined differently) correspond to functional layers 301 to 306 as described in relation to FIG. 3. The dashed lines suggest shallow etches in a sublayer used to define rib geometries. Two shallow etches are utilized, one in sublayer 601a to define confinement for optical mode 650 and one in sublayer 601b to define confinement for optical mode 651. Multiple tapers are utilized to facilitate efficient transition from mode 650 to 651 as shown in FIG. 6 utilizing adiabatic or close to adiabatic transformation. In a close to adiabatic transformation, the dimension change of a taper might be too rapid resulting in increased scattering losses. This might be preferred if e.g., the taper structure exhibits high material loss. All etches are defined using common alignment marks 620, one of which is shown. Various optimizations of the taper shapes and dimensions are possible to account for various material differences between layer and process related imperfections (such as alignment precision, sidewall angle, undercut, etc.).

The optical mode 651 supported by active layer 601b in region "B" is guided through optional coating layer 606 to layer 603 that supports optical mode 652 and serves to convert the mode for efficient coupling to layer 602 which supports mode 653. Layer 606 can provide high-reflection functionality, or can facilitate reduced reflection when designed to function as anti-reflection coating. The transition from mode 650 to 651 utilizes at least one taper, the transition from mode 651 to 652 utilizes butt-coupling (no adiabatic transition), while the transition from mode 652 to 653 utilizes at least one more taper. The requirements on taper tip dimensions, in transitions where tapers are utilized, are reduced due to the use of butt-coupling when transitioning between layers with largest difference in refractive indices (layer 601 and 603) as also described with the help of FIG. 3.

In some embodiments (not shown), one or more of the interfaces between layers 601, 606 and/or 603 are angled to reduce corresponding back reflection(s) as is known in the art of butt-coupled interfaces. In other embodiments (and as also shown in FIG. 6), they are perpendicular to the direction of the propagation of the mode 651 to intentionally provide reflection, e.g. in the case of Fabry-Perot lasers or similar structures.

It is to be understood that these illustrative embodiments teach just several examples of heterogeneously integrated lasers and active components optimized for high-power operation utilizing the present invention, and many similar arrangements can be further envisioned. Furthermore, such lasers and active components can be combined with multiple other components to provide additional functionality or better performance such as various filtering elements, amplifiers, monitor photodiodes, modulators and/or other photonic components.

Embodiments of the present invention offer many benefits. The integration platform enables scalable manufacturing of PICs made from multiple materials providing higher-performance and/or ability to operate in broadband wavelength range. Furthermore, the platform is capable of handling high optical power compared to typical Si waveguide-based or InP waveguide-based PICs.

This present invention utilizes a process flow consisting of typically wafer-bonding of a piece of compound semiconductor material on a carrier wafer with dielectric waveguides (as is described with the help of FIGs. 1 and 3) and subsequent semiconductor fabrication processes as is known in the art. It enables an accurate definition of optical alignment between components via typically photo lithography step, removing the need for precise physical alignment. Said photo lithography-based alignment allows for scalable manufacturing using wafer scale techniques.

Embodiments of the optical devices described herein may be incorporated into various other devices and systems including, but not limited to, various computing and/or consumer electronic devices/appliances, communication systems, medical devices, sensors and sensing systems.

It is to be understood that the disclosure teaches just few examples of the illustrative embodiment and that many variations of the invention can easily be devised by those skilled in the art after reading this disclosure and that the scope of the present invention is to be determined by the following claims.

Further embodiments:
1. A device comprising:
   an active structure attached to a substrate, the active structure comprising:
      a facet through which light couples between the active structure and another structure attached to the substrate; and
      an active region comprising a quantum well region that includes a sub-region, adjacent the facet, configured to undergo Quantum Well Intermixing (QWI) in response to heat;
   a heating element, positioned close to the facet and operable such that heat generated by the heating element raises a temperature of the sub-region of the active region near the facet high enough to activate QWI in that sub-region, in turn causing a reduction in optical absorption, without raising temperatures in any other portion of the active region high enough to cause significant thermal stress at any interface between the substrate and the active structure.
2. The device of embodiment 1,
   wherein the operation of the heating element allows an optical power density of at least 10mW/µm² to be handled without risking catastrophic optical mirror damage (COMD).
3. The device of embodiment 1, further comprising a passive structure attached to the su bstrate;
   wherein the passive structure is configured to couple optically, directly or indirectly, to the active structure.
4. The device of embodiment 1,
   wherein the optical coupling occurs at a lateral facet of the active structure; and
   wherein the lateral facet is angled at a value optimized to minimize reflections.
5. The device of embodiment 1,
   wherein the heating element is located in an upper cladding layer overlying the facet.
6. The device of embodiment 1,
   wherein the heating element is located laterally with respect to the facet
7. The device of embodiment 1,
   wherein the heating element is located on the substrate, underlying the facet.
8. The device of embodiment 1,
   wherein the heating element comprises one of doped silicon and a metal.
9. A device comprising:
   a first passive structure attached to a substrate; and
   an active structure attached to the substrate, the active structure comprising:
      a passive portion comprising a first part and a second part; and
      an active portion comprising an active region, providing optical gain or absorption, the active portion having a tapered region comprising one or more tapers such that the active portion terminates at a predetermined axial position on the active structure;
      wherein the active portion overlies the first part of the passive portion and does not overlie the second part of the passive portion, the second part of the passive portion extending axially beyond the predetermined axial position;
      wherein the tapered portion is configured such that a first optical mode, overlapping at least in part with the active region, couples into a second optical mode in the second part of the passive region, the second optical mode having no interaction or overlap with the active region; and
      wherein the second portion of the passive region comprises a facet through which light couples between the active structure and the first passive structure.
10. The device of embodiment 9,
   wherein the first passive structure is an intermediate structure, optically coupled to a second passive structure attached to the substrate.
11. The device of embodiment 9 wherein a rib waveguide formed by a least one etch, performed through the active portion of the active structure, laterally confines the first optical mode in the active structure.
12. The device of embodiment 9, wherein a strip waveguide, formed by at least one etch, performed through the active portion of the active structure and the underlying first part of the passive portion of the active structure, laterally confines the first optical mode in the active structure.
13. The device of embodiment 9, wherein a rib waveguide formed by a least one etch, performed through the second part of the passive portion of the active structure, laterally confines the second optical mode in the active structure.
14. The device of embodiment 9, wherein a strip waveguide formed by a least one etch, performed through the second part of the passive portion of the active structure, laterally confines the second optical mode in the active structure.
15 The device of embodiment 9,
   wherein the tapered region comprises a first taper and a second taper;
   wherein a first shallow etch through the active portion defines a rib geometry laterally confining light as it travels through the first taper; and
   wherein a second shallow etch through the first and second parts of the passive portion defines a rib geometry laterally confining light as it travels through a second taper, the light transitioning between the first optical mode in the active portion and the second optical mode in the second part of the passive portion.
16. The device of embodiment 9,
   wherein the facet has a facet coating configured to provide a predetermined level of reflectivity.
17. The device of embodiment 9,
   wherein the facet is angled with respect to an axial direction of travel for light travelling through the active structure at a non-perpendicular angle.

## Claims

1. A device comprising:
an active structure attached to a substrate, the active structure comprising:
a facet through which light couples between the active structure and another structure attached to the substrate; and
an active region comprising a quantum well region that includes a sub-region, adjacent the facet, configured to undergo Quantum Well Intermixing (QWI) in response to heat;
a heating element, positioned close to the facet and operable such that heat generated by the heating element raises a temperature of the sub-region of the active region near the facet high enough to activate QWI in that sub-region, in turn causing a reduction in optical absorption, without raising temperatures in any other portion of the active region high enough to cause significant thermal stress at any interface between the substrate and the active structure.

2. The device of claim 1,
wherein the operation of the heating element allows an optical power density of at least 10mW/µm² to be handled without risking catastrophic optical mirror damage (COMD).

3. The device according to any of the preceding claims, further comprising a passive structure attached to the substrate;
wherein the passive structure is configured to couple optically, directly or indirectly, to the active structure.

4. The device according to any of the preceding claims,
wherein the optical coupling occurs at a lateral facet of the active structure; and
wherein the lateral facet is angled at a value optimized to minimize reflections.

5. The device according to any of the preceding claims,
wherein the heating element is located in an upper cladding layer overlying the facet.

6. The device according to any of the preceding claims,
wherein the heating element is located laterally with respect to the facet

7. The device according to any of the preceding claims,
wherein the heating element is located on the substrate, underlying the facet.

8. The device according to any of the preceding claims,
wherein the heating element comprises one of doped silicon and a metal.
